# EUROPÄISCHE PATENTSCHRIFT

(11) **EP 0 809 263 B1**
(45) Veröffentlichungstag und Bekanntmachung des Hinweises auf die Patenterteilung: **09.07.2003**
(21) Anmeldenummer: 97105615.5
(22) Anmeldetag: 04.04.1997
(51) Int. Cl.: H01F 17/00, H01F 17/06, H01F 1/153

(54) **Induktives Bauelement in flacher Bauform**
Flat-type inductive component
Composant inductif du type plat

(30) Priorität: 22.04.1996 DE 19615921
(43) Veröffentlichungstag der Anmeldung: 26.11.1997
(73) Patentinhaber: Vacuumschmelze GmbH, 63450 Hanau (DE)
(72) Erfinder: Richter, Jürgen, Dr., 61197 Florstadt (DE)
(74) Vertreter: Neunert, Peter Andreas

(56) Entgegenhaltungen:
- EP-A- 0 175 069
- EP-A- 0 271 657
- EP-A- 0 414 974
- EP-A- 0 473 875

## Beschreibung

Die Erfindung betrifft ein induktives Bauelement in flacher Bauform mit
- einem Magnetkern aus einem weichmagnetischen Material, der ein Mittelloch aufweist durch das eine oder mehrere Wicklungen geführt sind,
- einer ersten Leiterplatte mit Leiterbahnen, die Teil der Windungen einer Wicklung sind, sowie eine Aussparung auf der den Leiterbahnen gegenüberliegenden Seite der Leiterplatte, in die der Magnetkern eingelegt ist,
- einer zweiten Leiterplatte mit Leiterbahnen, die Teil der Windungen einer Wicklung sind,
- elektrisch leitenden Verbindungen zwischen den Leiterbahnen der beiden Leiterplatten derart, daß mindestens eine Wicklung um den Magnetkern gebildet wird.

In der Elektrotechnik und Elektronik besteht seit langem der Trend zur Miniaturisierung und Erzielung eines höheren Integrationsgrades der Bauelemente, um eine kostenoptimierte Leiterplattenbestückung zu erreichen. Bei passiven Bauelementen wurden hinsichtlich der Integration bei Widerständen und Kapazitäten beträchtliche Fortschritte erzielt. So werden beispielsweise in der Dickschichttechnik Widerstände direkt mit Widerstandspasten auf die Leiterplatten aufgebracht und der Widerstandswert über das Temperaturprofil durch einen Druck-Brennprozeß eingestellt. Der Feinabgleich erfolgt mittels Laser. Der Widerstand ist somit fester Bestandteil der Leiterplatte. Kapazitäten können durch Dielektrikaplättchen zwischen zwei Leiterbahnen in die Leiterplatte integriert werden. Induktive Bauelemente werden dagegen in der Regel nach wie vor als diskrete Bauelemente in oder auf die Leiterplatte eingelötet. Durch die traditionelle Herstellung von Induktivitäten als Drahtbewicklung auf einem Magnetkern sind zudem der Automatisierung der Fertigung Grenzen gesetzt. In den letzten Jahren sind bereits einige Vorschläge zur rationelleren Fertigung induktiver Bauelemente gemacht worden, bei denen die Wicklungen in Form von Leiterbahnen auf Leiterplatten (Platinen) ausgebildet sind oder von miteinander verbundenen Kupferstanzteilen gebildet werden. Entsprechende Ausführungen werden häufig als Planarinduktivitäten bezeichnet. Als Magnetkerne kommen dabei insbesondere geteilte Ferritbauformen wie EE-, EI- oder auch RM-Kombinationen zur Anwendung (vgl. z.B. DE-OS 3718383, DE-OS 4137776).

In der Veröffentlichung A.M. Lyons, D.W. Dahringer, R.L. Billings "Printed Circuit Board Magnetics: A New Approach to the Mass Production of Toroidal Transformers" ISHM 95 Proceeedings, S. 53ff. sind weitere Konstruktionen erwähnt, die zur Kostenreduzierung in der Fertigung induktiver Bauelemente beitragen sollen. Insbesondere wird dort, wie auch in der US 5,527,00, ein induktives Bauelement detailliert beschrieben, bei dem eine geschlossene Kernbauform eingesetzt wird. Hierbei sind zwei Leiterplatten vorgesehen, die in Form von Leiterbahnen jeweils Teile der Windungen einer Wicklung tragen. Beide Leiterplatten weisen eine geeignete Aussparung in Form von senkrecht zueinander angeordenten Nuten auf, in die ein flacher rechteckiger Magnetkern eingelegt ist, der eine zentral angeordnete Öffnung aufweist. Die Höhe des Magnetkerns ist dabei kleiner als die Summe der Tiefen der beiden Aussparungen in den Leiterplatten. Bei dem fertigen Bauelement sind die beiden Leiterplatten aufeinander angeordnet und umschließen den Magnetkern vollständig. Die auf den Leiterplatten vorhandenen Leiterbahnen sind in geeigneter Weise so miteinander leitfähig verbunden, daß sie eine oder mehrere Wicklungen bilden.

Nach der zitierten Veröffentlichung erfolgt diese Verbindung über durchkontaktierte Bohrungen an den Leiterbahnen, die mittels eines leitfähigen Klebers verbunden werden. Bei dem bekannten Übertrager sind die Wicklungen ineinander geschachtelt, so daß Windungen, die zu getrennten Wicklungen gehören, eng beieinander liegen. Die bei vielen Anwendungen einzuhaltenden einschlägigen Normen und Vorschriften schreiben nun aber häufig Mindestkriechstrecken zwischen Wicklungen mit unterschiedlichem Potential vor. Unter Kriechstrecke wird dabei der kürzeste entlang der Isolierung -in diesem Fall der Leiterplatte - gemessene Weg zwischen zwei leitfähigen Teilen (Leiterbahnen) verstanden. Erschwert wird die Einhaltung von Kriechstrecken durch hohe Windungszahlen mit entsprechend dichter Windungsanordnung.

Aufgabe der Erfindung ist es daher, ein gattungsgemäßes induktives Bauelement so zu verbessern, daß bei vorgegebener Bauelementgröße und vorgegebenen elektrischen bzw. magnetischen Anforderungen an das Bauelement eine Vergrößerung der Kriechstrecke zwischen Wicklungen auf unterschiedlichem Potential erreicht wird.

Als Lösung dieser Aufgabe wird ein induktives Bauelement gemäß Anspruch vorgeschlagen. Als Werkstoff für den Magnetkern dient eine an sich bekannte, nanokristalline Eisenbasislegierung mit einer Korngröße von weniger als 100 nm oder eine ebenfalls an sich bekannte Kobaltbasislegierung, wobei das Magnetmaterial eine Sättigungsinduktion von mehr als 0,6 T und/oder eine Permeabilität von mehr als 10000, insbesondere mehr als 20000, aufweist und die Höhe des Magnetkerns nicht mehr als 2 mm beträgt. Durch die Verwendung dieser Magnetkerne kann die Windungszahl gegenüber Ferritkernen, bei denen die Sättigungsinduktion auf Werte unterhalb 0,5 T und die Permeabilität auf maximal etwa 10000 beschränkt ist, reduziert werden, wie im weiteren noch gezeigt wird. Dies kann zur Erhöhung der Kriechstrecke zwischen Wicklungen auf unterschiedlichem Potential ausgenutzt werden.

Weiterhin wird vorgeschlagen, die Wicklungen auf getrennten Sektoren anzuordnen und zwischen den Sektoren Nuten in den Leiterplatten zur Vergrößerung der Kriechstrecke zwischen den Wicklungen vorzusehen.

Als Magnetkerne können zum einen Ringkerne, insbesondere Ringbandkerne, eingesetzt werden. Die Herstellung von Ringbandkernen wird jedoch mit abnehmender Kernhöhe (gleich Breite des aufzuwickelnden Bandes) zunehmend schwieriger, so daß bei sehr geringen Kernhöhen von z.B. 1 mm oder weniger auch aus geschichteten Formteilen (z.B. Stanzteilen) hergestellte Kerne vorteilhaft eingesetzt werden können.

Weitere vorteilhafte Ausgestaltungen sind in den abhängigen Ansprüchen beschrieben.

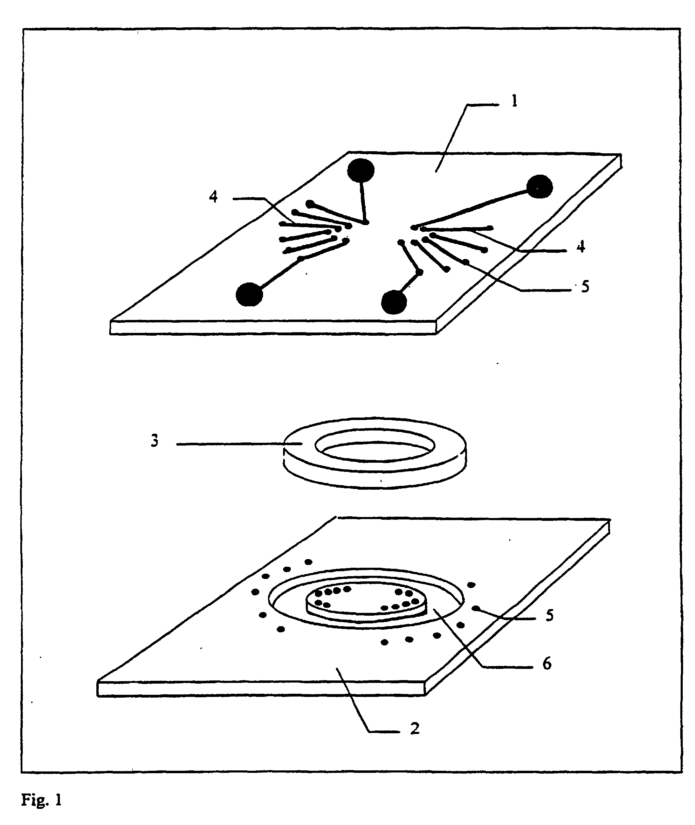

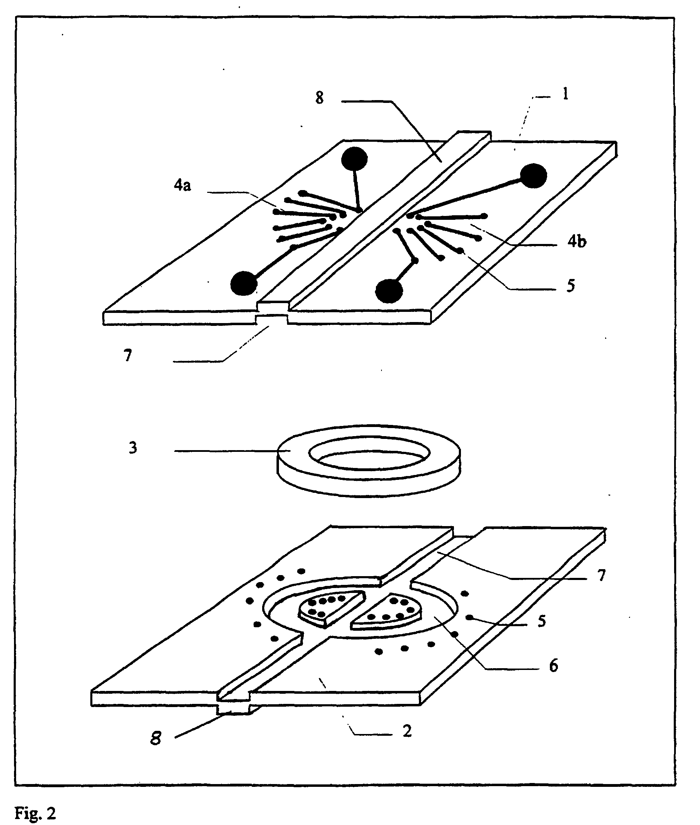

Die Erfindung wird nachfolgend anhand der Fig. 1 und 2 näher beschrieben. Es zeigen:
- Fig. 1: eine Gesamtansicht des Bauelements als Explosionszeichnung,
- Fig. 2: eine Gesamtansicht des Bauelements als Explosionszeichnung mit Nuten zur Vergrößerung der Kriechstrecke.

In Fig. 1 ist eine Gesamtansicht eines erfindungsgemäßen induktiven Bauelements dargestellt. Das Bauelement enthält eine erste und eine zweite Leiterplatte 1, 2, in die ein Magnetkern 3 eingelegt ist. Die Leiterplatten 1, 2 weisen jeweils an der dem Kern abgewandten Seite Leiterbahnen 4 auf. Die Enden der Leiterbahnen 4 sind mit Durchgangslöchern 5 versehen, durch die eine leitfähige Verbindung der entsprechenden Leiterbahnen 4 auf den Leiterplatten 1, 2 erfolgt, so daß eine oder mehrere Wicklungen um den Kern 3 ausgebildet werden. Auf der den Leiterbahnen 4 gegenüberliegenden Seite der Leiterplatten 1, 2 sind Aussparungen 6 vorhanden, in die der Kern 3 eingelegt ist. Die Tiefe der Aussparungen 6 ist dabei so gewählt, daß der Kern 3 vollständig von diesen aufgenommen wird und die Leiterplatten 1, 2 formschlüssig zusammengefügt sind. Die Aussparung 6 braucht auch nur in einer der beiden Leiterplatten 1, 2 vorhanden zu sein. In diesem Fall können die Leiterbahnen der Leiterplatte ohne Aussparung auch auf der dem Kern 3 zugewandten Seite angebracht sein. Die Verbindung der Leiterbahnen 4 der Leiterplatten 1, 2 durch die Durchgangslöcher 5 zur Ausbildung mindestens einer Wicklung kann beispielsweise über Stifte, mittels eines leitfähigen Klebers, wie aus der eingangs genannten Veröffentlichung bekannt, oder über andere geeignete Verfahren erfolgen. Die beiden Leiterplatten 1, 2 mit dazwischenliegendem Kern 3 werden zweckmäßigerweise mittels einer Klebeverbindung zusammengehalten. Bei der in Fig. 2 dargestellten Ausführungsform sind die Leiterbahnen 4a zur Bildung einer ersten Wicklung und die Leiterbahnen 4b zur Bildung einer zweiten Wicklung vorgesehen und auf unterschiedlichen Sektoren angeordnet. Zur Vergrößerung der Kriechstrecke zwischen den beiden Wicklungen auf unterschiedlichem Potential sind ferner Nuten 7 in den Leiterplatten 1, 2 vorhanden. Auf der dem Kern 3 abgewandten Seite der Leiterplatten 1, 2 können anstelle von Nuten auch Erhöhungen 8 zur Vergrößerung der Kriechstrecke angebracht werden.

Jedoch kann auch ohne die Nuten 7 durch die Verwendung eines Magnetkerns mit ausgezeichneten magnetischen Eigenschaften, wie je nach Anwendung einer Sättigungsinduktion von mehr als 0,6 T und/oder einer Permeabilität von mehr als 10000, aufgrund der gegenüber Ferritmaterialien geringeren Windungszahlen eine ausreichend große Kriechstrecke erreicht werden.

Der Magnetkern 3 kann dazu erfindungsgemäß aus einer an sich bekannten nanokristallinen Eisenbasislegierung mit einer Korngröße von weniger als 100 nm oder aus einer amorphen Kobaltbasislegierung bestehen.

Nanokristalline Eisenbasislegierungen und Verfahren zu ihrer Herstellung sind aus der EP-OS 0 271 657 bekannt. Es handelt sich hierbei insbesondere um Legierungen, die neben Eisen im wesentlichen 0,1 bis 3 Atom-% Kupfer, 0,1 bis 30 Atom-% weitere Metalle, wie Nb, W, Ta, Zr, Hf, Ti, oder Mo, bis zu 30 Atom-% Silizium und bis zu 25 Atom-% Bor enthalten, wobei der Gesamtgehalt an Silizium und Bor im Bereich zwischen 5 und 30 Atom-% liegt. Legierungsbeispiele mit Sättigungsinduktion Bs und Permeabilität µ sind in Tabelle 1 aufgeführt. Die Permeabilität kann durch die Fertigungsparameter bei der Legierungs- und Kernherstellung beeinflußt werden.

**Tab. 1**

| Legierung | Bs (T) | µ |
|---|---|---|
| Fe₇₄Cu_{0,5}Si_{13,5}B₉Nb₃ | 1,2 | 68000 |
| Fe₇₄Cu₁Si₁₄B₈W₃ | 1,2 | 74000 |
| Fe₇₃Cu₂Si_{13,5}B_{8,5}Hf₃ | 1,1 | 29000 |
| (Fe_{0,905}Ni_{0,095})_{73,5}Cu₁Si1_{3,5}B₉Nb₃ | 1,2 | 16000 |

Geeignete Kobaltbasislegierungen beinhalten neben Kobalt im wesentlichen Eisen und Mangan mit einem Gesamtanteil von 3 bis 8 Atom-% sowie Metalloide mit einem Anteil von 5 bis 35 Atom-%. Entsprechende Legierungen sind beispielsweise aus der EP-PS 21101, der DE-OS 3 021 536 und der EP-OS 0 378 823 bekannt. Als Metalloide kommen Bor, Silizium, Kohlenstoff und Phosphor in Frage. Weiterhin können die amorphen Kobaltbasislegierungen auch Nickel mit einem Anteil von bis zu 15 Atom-% sowie eines oder mehrere der Elemente Molybdän, Chrom oder Niob mit einem Anteil von bis zu 5 Atom-% enthalten. Legierungsbeispiele mit Sättigunginduktivität Bs und Anfangspermeabiliät µᵢ sind in Tabelle 2 aufgeführt

**Tab. 2**

| Legierung | Bs (T) | µ_{*i*} |
|---|---|---|
| Fe₄Si_{16,8}B11Co_{R} | 0,63 | 38000 |
| Fe_{3,2}Mn₁Si_{16,3}B₁₁Co_{R} | 0,65 | 34000 |
| Fe_{0,4}Mn_{7,5}Ni₁₀Si_{11,5}B_{11,5}Co_{R} | 0,71 | 33000 |
| Mn₆Si₁₃B₁₃Co_{R} | 0,7 | 110000 |
| **R=Rest** | | |

Die Legierungen werden durch ein bekanntes Raschabschreckungsverfahren als dünne Bänder mit einer Banddicke von typischerweise etwa 20 bis 35 µm hergestellt. Aus den so gewonnenen Bändern werden beispielsweise Ringbandkerne gefertigt. Für Kerne mit sehr geringer Kernhöhe müssen entsprechend schmale Bänder zu Magnetkernen aufgewickelt werden. Ringbandkerne mit geringer Kernhöhe sind daher kaum wirtschaftlich herstellbar. Für Kerne mit geringer Höhe wird daher vorgeschlagen ringförmige oder rechteckige Formteile aus den Bändern einzusetzen, die übereinandergestapelt sind. Die Formteile können beispielsweise durch Stanzen gewonnen werden. Zur Bildung eines Magnetkerns mit einer Höhe von 0,5 mm werden beispielsweise bei einer Banddicke von 25 µm 20 solcher Formteile benötigt.

Die vorteilhafte Verwendung der genannten Magnetmaterialien wird nachfolgend am Beispiel eines Impulsübertragers verdeutlicht. Ein charakteristisches Merkmal von Impulsübertragern, wie sie beispielsweise zur Ansteuerung von Leistungshalbleitern eingesetzt werden, ist die sogenannte Spannungs-Zeitfläche ∫udt. Die Spannungs-Zeitfläche des Übertragers muß größer sein als die Spannungs-Zeitfläche des zu übertragenden Impulses, da der Übertrager ansonsten gesättigt und der Impuls nicht vollständig übertragen wird. Die Spannungs-Zeitfläche des Übertragers läßt sich aus der Windungszahl N des Übertragers, dem Eisenquerschnitt A_{Fe} des Magnetkerns und dem zur Verfügung stehenden unipolaren Induktionshub ΔB des Magnetwerkstoffs berechnen zu ∫udt = N*A_{Fe}*ΔB. Bei vorgegebener Kerngröße (und damit A_{Fe}) und einer bestimmten geforderten Spannungszeitfläche wird daher die Windungszahl umso kleiner gewählt werden können, je größer der zur Verfügung stehende Induktionshub ΔB des Magnetmaterials ist. Der zur Verfügung stehende Induktionshub ist bei den erfindungsgemäß verwendeten Magnetwerkstoffen wesentlich größer als bei Ferritwerkstoffen. Beispielsweise weisen die genannten nanokristallinen Werkstoffe eine Sättigungsinduktion von etwa 1,2 T auf, während die Sättigungsinduktion von Ferriten etwa im Bereich von 0,4 bis 0,5 T liegt. Aufgrund des Permeabilitätsabfalls bei hoher Aussteuerung ist der für die Auslegung des Übertragers zur Verfügung stehende Induktionshub in beiden Fällen etwas geringer.

Beispiel: Ein Magnetkern aus einer nanokristallinen Legierung mit einer Sättigungsinduktion von 1,2 T wird für ein erfindungsgemäßes induktives Bauelement eingesetzt. Für die Auslegung des Übertragers wird ein nutzbarer Induktionshub von 1,0 T zugrunde gelegt. Ein Magnetkern der Abmessungen 6,5x3,5x1,5 mm weist bei einem Füllfaktor von 0,8 einen Eisenquerschnitt von A_{Fe} = 1,8 mm² auf. Eine geforderte Spannungs-Zeitfläche von 9 µVs kann dann bereits mit 5 Windungen erreicht werden. Bei Verwendung von Ferritkernen wäre dagegen aufgrund des geringeren zur Verfügung stehenden Induktionshubes von weniger als 0,4 T (Beispiel Ferrit T38: Bs = 0,38 T) eine mehr als doppelt so große Windungszahl erforderlich. Durch die geringere Windungszahl bei der erfindungsgemäßen Ausführung ist daher der Abstand zwischen den Wicklungen und damit die Kriechstrecke größer. Beispielsweise wird nach der Europa-Norm EN 60950 bei einer Betriebsspannung von 250 V, Isolierstoffklasse I und Verschmutzungsgrad 2 für eine zusätzliche Isolierung eine Kriechstrecke von 1,3 mm verlangt, die mit dem erfindungsgemäßen induktiven Übertrager leichter realisiert werden kann.

Bei anderen Übertragern, beispielsweise Schnittstellenübertragern für die Kommunikationstechnik, ist die erreichbare Induktivität von Bedeutung. Die Induktivität ist direkt proportional zur Permeabilität µ und zum Quadrat der Windungszahl N, sodaß auch bei diesen Übertragern durch die erfindungsgemäß eingesetzten Magnetwerkstoffe hoher Permeabilität von typischerweise 20000 bis 80000 eine Verkleinerung der Windungszahl und damit verbunden eine Vergrößerung der Kriechstrecke erreicht wird. Zum Vergleich beträgt die Permeabilität eines hochpermeablen, kommerziellen Ferritmaterials (z.B. T38) etwa 10000.

Das erfindungsgemäße Bauelement kann sowohl als diskretes Bauelement mit Anschlußstiften als auch als SMD-Bauelement ausgelegt werden. In einer besonderen Ausführungsform beinhaltet mindestens eine der beiden Leiterplatten 1, 2 neben den Leiterbahnen 5 noch weitere aktive und/oder passive Bauelemente und die zugehörige Verschaltung.

## Patentansprüche

1. Induktives Bauelement in flacher Bauform mit
einem Magnetkern (3) aus einem weichmagnetischen Material, der ein Mittelloch aufweist durch das eine oder mehrere Wicklungen geführt sind,
einer ersten Leiterplatte (1) mit Leiterbahnen, die Teil der Windungen einer Wicklung sind, sowie eine Aussparung (6) auf der den Leiterbahnen (4) gegenüberliegenden Seite der Leiterplatte (1), in die der Magnetkern (3) eingelegt ist,
einer zweiten Leiterplatte (2) mit Leiterbahnen, die Teil der Windungen einer Wicklung sind,
elektrisch leitenden Verbindungen zwischen den Leiterbahnen (4) der beiden Leiterplatten derart, daß mindestens eine Wicklung um den Magnetkern (3) gebildet wird, **dadurch gekennzeichnet,**
**daß** der Magnetkern (3) aus einer nanokristallinen Eisenbasislegierung mit einer Korngröße von weniger als 100 nm oder aus einer amorphen Kobaltbasislegierung besteht,
**daß** das Magnetmaterial eine Sättigungsinduktion von mehr als 0,6 T aufweist und
**daß** die Höhe des Magnetkerns nicht mehr als 2 mm beträgt.

2. Induktives Bauelement nach Anspruch 1, **dadurch gekennzeichnet,**
**daß** die nanokristalline Legierung neben dem Hauptbestandteil Eisen und üblichen Verunreinigungen 0,1 bis 3 Atom-% Kupfer, 0,1 bis 30 Atom-% weitere Metalle, wie Nb, W, Ta, Zr, Hf, Ti, oder Mo, bis zu 30 Atom-% Silizium und bis zu 25 Atom-% Bor enthält,
wobei der Gesamtgehalt an Silizium und Bor im Bereich zwischen 5 und 30 Atom-% liegt.

3. Induktives Bauelement nach Anspruch 1, **dadurch gekennzeichnet,**
**daß** die amorphe Kobaltbasislegierung neben Kobalt und üblichen Verunreinigungen im wesentlichen Eisen und Mangan mit einem Gesamtanteil von 3 bis 8 Atom-%, Metalloide, wie Bor, Silizium, Kohlenstoff und Phosphor, mit einem Anteil von 5 bis 35 Atom-%, Nickel mit einem Anteil von bis zu 15 Atom-% sowie eines oder mehrere der Elemente Molybdän, Chrom oder Niob mit einem Anteil von bis zu 5 Atom-% enthält.

4. Induktives Bauelement nach einem der vorhergehenden Ansprüche, **dadurch gekennzeichnet,**
**daß** das Bauelement mindestens zwei Wicklungen aufweist, die als Sektorwicklungen ausgebildet sind und
**daß** zwischen den Sektoren Nuten (7) in der Leiterplatte (1, 2) zur Vergrößerung der Kriechstrecke zwischen den Wicklungen vorhanden sind.

5. Induktives Bauelement nach einem der vorhergehenden Ansprüche, **gekennzeichnet**
**durch** eine Kriechstrecke von mindestens 1,3 mm zwischen zwei Wicklungen.

6. Induktives Bauelement nach einem der vorhergehenden Ansprüche, **dadurch gekennzeichnet,**
**daß** es sich bei dem Magnetkern (3} um einen Ringkern, insbesondere um einen Ringbandkern, handelt.

7. Induktives Bauelement nach einem der vorhergehenden Ansprüche, **dadurch gekennzeichnet,**
**daß** der Magnetkern (3) aus aufeinander gestapelten Folien des Magnetmaterials gebildet wird, wobei die Foliendicke weniger als 35 µm beträgt.

8. Induktives Bauelement nach einem der vorhergehenden Ansprüche, **dadurch gekennzeichnet,**
**daß** beide Leiterplatten (1, 2) eine Aussparung (6) zur Aufnahme des Magnetkerns (3) aufweisen.

9. Induktives Bauelement nach einem der vorhergehenden Ansprüche, **dadurch gekennzeichnet,**
**daß** eine der beiden Leiterplatten (1, 2) weitere Bauelemente einer elektronischen Schaltung enthält.

10. Induktives Bauelement nach einem der vorhergehenden Ansprüche, **dadurch gekennzeichnet,**
**daß** der Magnetkern (3) eine Permeabilität von mehr als 10000 aufweist.

## Claims

1. Flat inductive component comprising a magnetic core (3) made of a soft-magnetic material and having a centre hole through which one or more windings are guided, a first printed circuit board (1) with conductor tracks forming part of the turns of a winding, as well as a recess (6) on the side of the printed circuit board (1) opposite the conductor tracks (4) into which the magnetic core (3) is inserted, a second printed circuit board (2) with conductor tracks forming part of the turns of a winding, and bonds between the conductor tracks (4) of the two printed circuit boards, such that at least one winding is formed around the magnetic core (3), **characterised in that** the magnetic core (3) consists of a nanocrystalline iron-base alloy having a grain size of less than 100 nm or of an amorphous cobalt-base alloy, that the magnetic material displays saturation induction of more than 0.6 T and that the height of the magnetic core is no more than 2 mm.

2. Inductive component according to claim 1, **characterised in that**, in addition to the main constituent, i.e. iron, and the usual impurities, the nanocrystalline alloy contains 0.1 to 3 atomic % copper, 0.1 to 30 atomic % of other metals, such as Nb, W, Ta, Zr, Hf, Ti or Mo, up to 30 atomic % silicon and up to 25 atomic % boron, the total silicon and boron content being in the region of between 5 and 30 atomic %.

3. Inductive component according to claim 1, **characterised in that**, in addition to cobalt and the usual impurities, the amorphous cobalt-base alloy contains essentially a total of 3 to 8 atomic % iron and manganese, 5 to 35 atomic % metalloids, such as boron, silicon, carbon and phosphorus, up to 15 atomic % nickel, as well as up to 5 atomic % of one or more of the elements molybdenum, chromium or niobium.

4. Inductive component according to one of the preceding claims, **characterised in that** the component has at least two windings in the form of sector windings and that grooves (7) are provided in the printed circuit board (1, 2) between the sectors in order to increase the creepage distance between the windings.

5. Inductive component according to one of the preceding claims, **characterised by** a creepage distance of at least 1.3 mm between two windings.

6. Inductive component according to one of the preceding claims, **characterised in that** the magnetic core (3) is a toroidal core, in particular a strip-wound toroidal core.

7. Inductive component according to one of the preceding claims, **characterised in that** the magnetic core (3) is formed of foils of the magnetic material stacked one on top of the other, the foil thickness being less than 35 µm.

8. Inductive component according to one of the preceding claims, **characterised in that** both of the printed circuit boards (1, 2) have a recess (6) for receiving the magnetic core (3).

9. Inductive component according to one of the preceding claims, **characterised in that** one of the two printed circuit boards (1, 2) contains other components of an electronic circuit.

10. Inductive component according to one of the preceding claims, **characterised in that** the magnetic core (3) displays permeability of more than 10000.

## Revendications

1. Composant inductif de type plat, comprenant
- un noyau magnétique (3) fait d'un matériau magnétique doux, et percé d'un trou central traversé par un ou plusieurs enroulements,
- un premier circuit imprimé (1) avec des pistes conductrices qui font partie des spires d'un enroulement, ainsi qu'un évidement (6) creusé dans la face du circuit imprimé (1) située à l'opposé des pistes conductrices (4), et logeant le noyau (3),
- un second circuit imprimé (2) avec des pistes conductrices qui font partie des spires d'un enroulement,
- des liaisons conductrices de l'électricité reliant les pistes conductrices (4) des deux circuits imprimés de manière à créer au moins un enroulement autour du noyau magnétique (3),
**caractérisé en ce que**
- le noyau magnétique (3) est constitué par un alliage nanocristallin à base de fer, de granulométrie au moins égale à 100 nm, ou par un alliage amorphe à base de cobalt,
- le matériau magnétique présente une induction de saturation d'au moins 0,6 T,
- la hauteur du noyau magnétique ne dépasse pas 2 mm.

2. Composant inductif selon la revendication 1,
**caractérisé en ce que**
l'alliage nanocristallin, en plus de son composé principal et des impuretés usuelles, contient 0,1 à 3 % d'atomes de cuivre, 0,1 à 30 % d'atomes d'autres métaux tels que Nb, W, Ta, Zr, Hf, Ti ou Mo, jusqu'à 30 % d'atomes de silicium et jusqu'à 25 % d'atomes de bore, la teneur totale en silicium et bore étant comprise entre 5 et 30 %.

3. Composant inductif selon la revendication 1,
**caractérisé en ce que**
l'alliage amorphe à base de cobalt contient en plus du cobalt et des impuretés usuelles, essentiellement du fer et du manganèse avec une teneur totale d'atomes de 3 à 8 %, des métalloïdes comme le bore, le silicium, le carbone et le phosphore, avec une teneur totale en atomes de 35 %, du nickel avec une teneur en atomes jusqu'à 15 %, ainsi qu'un ou plusieurs des éléments molybdène, chrome ou niobium avec une teneur en atomes allant jusqu'à 5 %.

4. Composant inductif selon l'une des revendications précédentes,
**caractérisé en ce que**
le composant présente au moins deux enroulements qui sont disposés sur des secteurs, entre lesquels les circuits imprimés (1, 2) présentent des rainures (7) pour augmenter la ligne de fuite entre les enroulements.

5. Composant inductif selon l'une des revendications précédentes,
**caractérisé en ce que**
la ligne de fuite entre deux enroulements est d'au moins 1,3 mm.

6. Composant inductif selon l'une des revendications précédentes,
**caractérisé en ce que**
le noyau magnétique (3) est un noyau annulaire, notamment un noyau à bande annulaire.

7. Composant inductif selon l'une des revendications précédentes,
**caractérisé en ce que**
le noyau magnétique (3) est constitué de feuilles de matériau magnétique empilées les unes sur les autres, chaque feuille ayant une épaisseur inférieure à 35 microns.

8. Composant inductif selon l'une des revendications précédentes,
**caractérisé en ce que**
les deux circuits imprimés (1, 2) présentent chacun un évidement pour accueillir le noyau magnétique (3).

9. Composant inductif selon l'une des revendications précédentes,
**caractérisé en ce qu'**
un des circuits imprimés (1,2) contient d'autres éléments d'un circuit électronique.

10. Composant inductif selon l'une des revendications précédentes,
**caractérisé en ce que**
le noyau magnétique (3) a une perméabilité supérieure à 10000.
